# EUROPEAN PATENT APPLICATION

(11) **EP 1 154 574 A2**
(43) Date of publication of application: **14.11.2001**
(21) Application number: 01109878.7
(22) Date of filing: 23.04.2001
(51) Int. Cl.: H03M 7/30

(54) **Method for compressing data using trend information**

(30) Priority: 08.05.2000 JP 2000134118
(71) Applicant: Mitsubishi Heavy Industries, Ltd., Tokyo (JP)
(72) Inventor: Emoto, Hideaki, Mitsubishi Heavy Industries, Ltd., Takasago-shi, Hyogo (JP); Sagawa, Isao, Mitsubishi Heavy Industries, Ltd., Takasago-shi, Hyogo (JP)
(74) Representative: Henkel, Feiler, Hänzel

(57) **Abstract**

A purpose of the present invention is to provide high level compression system so as to improve a data transmitting efficiency. In the case of transmitting data in which a characteristic curve is very important to a remote site, a predetermined number of the above data are collected at a transmitting site (10) so as to dummy-picture the data (S2). The dummy pictured data is highly compressed by a picture compression treatment (S3). The compressed dummy-pictured data is transmitted to the receiving site (20). At the receiving site (20), the received compressed dummy pictured data is recovered to the dummy pictured data (T1). The dummy pictured data is divided into the predetermined number of the parts so that original data can be reproduced (T2).

## Description

The entire disclosure of Japanese Patent Application No. 2000-134118 filed on May 8, 2000 including specification, claims, drawings and summary is incorporated herein by reference in its entirety.

### Background of the Invention

The present invention relates to a process and an apparatus for transmitting data for a purpose of notifying a trend and a characteristic amount concerning about information when the data is transmitted to a remote place.

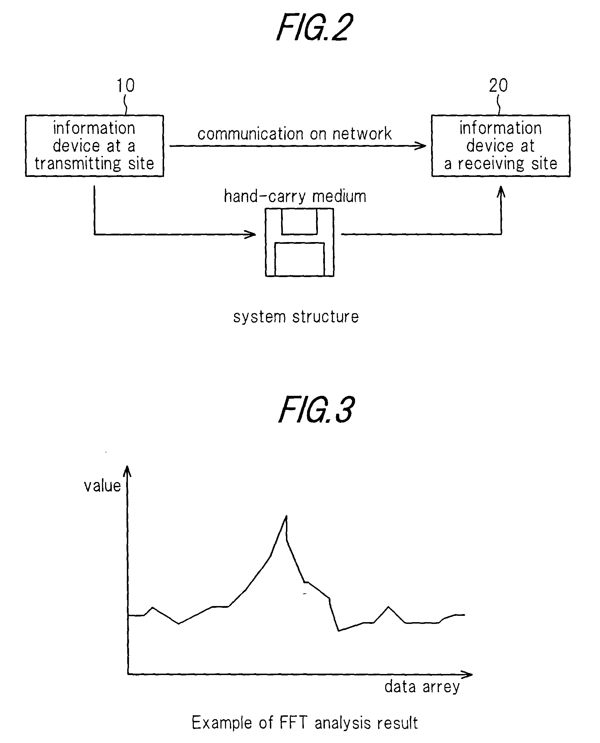

As shown in Fig. 2, in the case of transmitting data stored in a transmitting information device 10 such as a personal computer and a workstation to an information receiving device 20 located at a remote place, it has been utilized a network system and a hand-carry medium such as a floppy disc. In such a case, the data is usually compressed and transmitted depending on a communication band of the network and a capacity of the hand-carry medium.

In a conventional art, it has been employed a compression method, if the compression can recover compressed data certainly.

However, in the case of transmitting data of which a regularity degree is relatively low such as FFT analysis data, the above described method is improper since a compression ratio and a transmitting efficiency are relatively low.

### Summary of the Invention

To resolve the above subject, compression means according to the present invention as converts the predetermined number of data stored in an information transmitting device into dummy picture, compresses the dummy picture in accordance with a picture compression treatment and transmits the compressed dummy picture to an information receiving device in the case that data includes an important characteristic curve. The compression means receives the compressed dummy picture, reproduces the dummy data and divides the reproduced dummy picture into the predetermined number of data sections so as to recover the original data at an information receiving device.

### Brief Description of the Drawings

Fig. 1 shows the first embodiment according to the present invention.
Fig. 2 is a drawing for explaining an idea of the present invention for transmitting data.
Fig. 3 shows one example of FFT analysis data.
Fig. 4 shows one example of a plurality of the FFT analysis data collected at a predetermined interval.
Fig. 5 is a drawing for explaining dummy-picturing data corresponding to the data as shown in Fig. 4.

### Detailed Description of the Preferred Embodiment

As shown in Fig. 2, the present invention is suitable for the case for transmitting data stored in an information transmitting device 10 transmitted to an information receiving device 20 through a network system or a hand-carry medium such as a floppy disc.

In the case of transmitting data including an important characteristic curve such as FET analysis data to a remote site, it is more important to notify the characteristics and trend of the original data than to reproduce the data faithfully. Thus, the prevent invention combines a technique of dummy picturing and a technique of compressing a picture in order to transmit the characteristics and the trend of the original data more efficiently.

As shown in Fig. 3, the FFT analysis data, of which an amount corresponds to a data array such as frequency, is one-dimensional data.

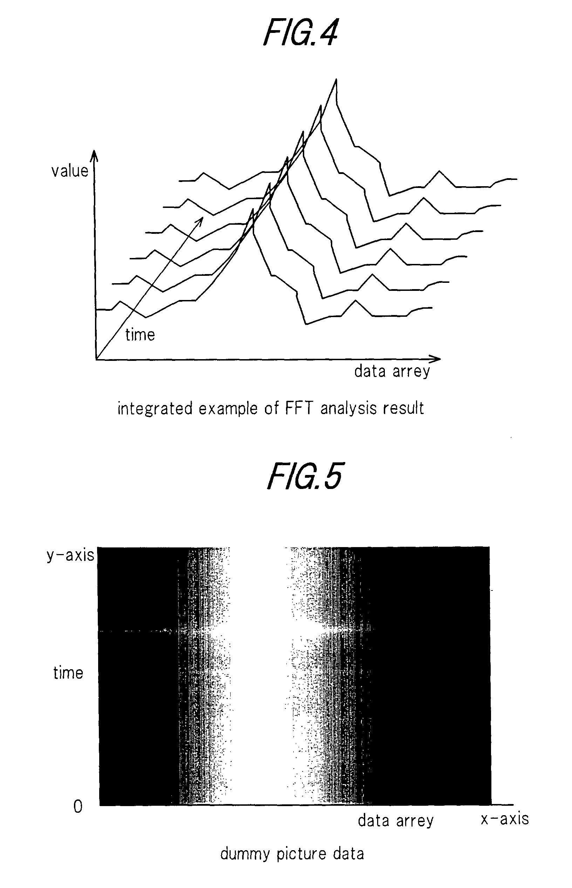

A plurality of these FFT data are collected for every predetermined interval so as to form two dimensional data group including a time elapse axis as shown in Fig. 4.

An amount of the data group for each point is indicated as brightness so as to form a dummy picture data, in which a X-axis is the data array and a Y-axis is time elapse, as shown in Fig. 5.

That is, the higher the brightness level becomes, the higher the amount of the data becomes in the dummy picture data.

The dummy picture data is highly compressed by picture compression means.

In general, regarding a normal picture compression method such as JPEG, characteristics of compressed picture data are preserved although slight brightness difference between each points is ignored.

By ignoring such a difference, the characteristics of the data can be faithfully reproduced at a high level and a high compression ratio can be obtained although the reproduced picture is not completely equal.

In the present invention, dummy pictured data is highly compressed by the above picture compression method and reproduced to the original two dimension data as shown in Fig. 4.

As described above, the technique of the dummy picturing and the technique of picture compression are combined in the present invention so that the characteristic amount and the trend of the data can be faithfully preserved at a certain level and a high compression can be accomplished.

The more the data is compressed, the more information transmitted per one unit time is increased in a network communication. Upon comparing with the conventional art and the present invention, if an information amount is the same, transmitting speed of the present invention is faster than that of the conventional art.

In the case of a hand-carry medium as shown in Fig. 2, more information can be recorded in one medium.
For example, although it depends on a content of data an original data amount (100%) can be compressed to an amount of 10% to 20% with respect to the original data amount by compressing dummy picturing data in accordance with the present invention. On the other hand, in a conventional compression method for compressing FFT analysis, an original data amount can be compressed to an amount of 80% to 90%.

### [Embodiment 1]

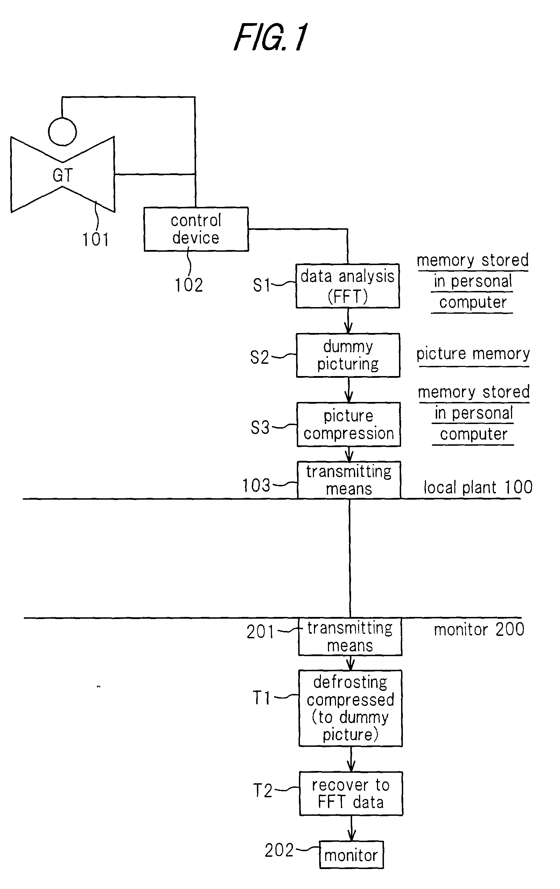

A first embodiment of the present invention is shown in Fig. 1.

The first embodiment is suitable for a remote supervisory with respect to a local plant 100.
At the local plant 100, a gas turbine 101 is controlled by a control device 102 and burning vibration, pressure vibration, axial vibration, sound vibration and so on caused by the gas turbine 101 are detected.

It is necessary to compress and transmit the detected data so as to be analyzed by a monitor site 200 located at a remote place.

The data detected by the control device 102 at the local plant 100 is FFT analyzed (S1) so as to form one dimensional data corresponding to the data array.

A plurality of FFT analyzed data are collected for every predetermined interval so as to form two dimensional data group including a time elapse axis. An amount of the data group at each point is indicated as brightness so as to form dummy picture data in which a X-axis is a data array and a Y-axis is a time elapse (S2).

Further, the dummy picture data is picture-compressed by a picture compression method so as to transmit the compressed dummy picture data from transmitting means 103 at the local plant 100 to transmitting means 201 at a monitoring site 200 (S3).

At the monitoring site 200, the transmitted compressed data is reforested so as to reproduce to the dummy picture data (T1). Further, the dummy picture data is recovered to the original FFT analysis data (T2) and it is displayed on a monitor 202.

In the present invention, dummy picture data can be picture-compressed at a high compression ratio and transmitted from the local plant 100 to the monitoring site 200 so that characteristics and trend of various information about the gas turbine 101 located at the local plant 100 can be collectedly acknowledged at the monitoring site located at a remote site and a transmitting time can be shortened.

If there is a doubt of abnormal condition judging from the result of the analysis, the conventional method such as FFT analysis data may be used to faithfully recover the original data in addition to the dummy picture data.

### [Other embodiments]

The present invention is suitable for a device for always monitoring vibration conditions of a machine at a remote place (for example, an observation camera).

Accordingly, in order to obtain characteristic amount of a picture photographed by an observation camera FFT analysis device is provided. According to the result of continuous analysis by the device, the monitoring can be accomplished at a remote site.

In addition, the FFT analysis is also used for analyzing frequency components sounded from a machine. Such an analysis can be accomplished at a remote site.

As described above with reference to the embodiments of the present invention, in the case of transmitting data including an important characteristic curve to a remote place, a predetermined number of the data are collected at a transmitting site so as to dummy-picture the data. The dummy-pictured data is compressed at a high compression ratio by a picture compression treatment. At a receiving side, the compressed dummy picture data is received and recovered to the dummy picture data. By dividing the received dummy picture data into the predetermined number of sections, the original data can be reproduced. Thus, the data is compressed at a high compression level so that a transmitting efficiency can be improved.

The present invention is, of course, in no way restricted to the specific disclosure of the specification and drawings, but also encompasses any modifications within the scope of the appended claims.

## Claims

1. A communication process **characterized** of comprising
a step (S2) for dummy-picturing data consisting of a predetermined number of original data; and
a step (S3) for highly compressing dummy pictured data by a picture compression treatment;
said communication process further comprising:
a step for transmitting said dummy pictured data compressed in the previous step;
a step (T1) for reproducing said dummy pictured data transmitted in the pervious step; and
a step (T2) for dividing said dummy pictured data into said predetermined number of original data so as to reproduce said original data.

2. A communication process **characterized** of comprising a step (S2) for dummy-picturing data consisting of a predetermined number of original data including important information about characteristic curves and a step (S3) for highly compressing a dummy pictured data by a picture compression treatment;
wherein said communication process further comprises a step for transmitting a compressed dummy pictured data;
a step (T1) for reproducing said dummy pictured data transmitted in the previous step; and
a step (T2) for dividing said dummy pictured data reproduced in the previous step into said predetermined number of original data so as to reproduce said original data.

3. A communication process for observing a plant located at a remote site **characterized** of comprising a step (S2) for dummy-picturing data consisting of a predetermined number of original data including important information about characteristic curves and a step (S3) for highly compressing dummy pictured data by a picture compression treatment,
wherein said communication process further comprises :
a step for transmitting said dummy pictured data compressed in the previous step;
a step (T1) for reproducing said dummy pictured data transmitted in the pervious step; and
astep (T2) for dividing said compressed dummy pictured data into said predetermined number so as to reproduce said data.

4. A dummy picture compression signal **characterized in that** dummy picture consisting of a predetermined number of original data is highly compressed in a picture compression treatment.

5. A dummy picture compression signal **characterized in that** dummy picture consisting of a predetermined number of original data including important information about characteristic curves and said dummy picture is highly compressed by a picture compression treatment.

6. A dummy picture compression signal for observing a plant located at a remote site, said dummy picture compression signal **characterized in that** said dummy picture consisting of a predetermined number of original data is highly compressed by a picture compression treatment.

7. A data compression process for transmitting data to a remote site, said data compression process **characterized** of comprising:
a step (S2) for dummy picturing said data consisting of a predetermined number of original data at a transmitting site,
a step (S3) for highly compressing said dummy pictured data by a picture compression treatment,
a step for transmitting said dummy pictured data compressed in the previous step to a receiving site,
a step (T1) for recovering said data received at said receiving site so as to reproduce said dummy pictured data, and
a step (T2) for dividing said dummy picture into said predetermined number of said original data.

8. A data compression process for transmitting data including important information about characteristic curves to a remote site, said data compression process **characterized** of comprising:
a step (S1) for dummy picturing said data consisting of a predetermined number of original data at a transmitting site,
a step (S2) for highly compressing said dummy pictured data in the previous step by a picture compression treatment,
a step for transmitting said dummy pictured data compressed in the previous step to a receiving site,
a step (T1) for recovering said dummy pictured data received in the previous step so as to reproduce said dummy picture, and
a step (T2) for dividing said dummy pictured data into said predetermined number of said original data.

9. A data compression process for transmitting data observed at a plant located at a remote site including important information about characteristic curves to a remote site, data compression process **characterized** of comprising:
a step (S2) for dummy picturing said data consisting of a predetermined number of original data at a transmitting site,
a step (S3) for highly compressing said data dummy pictured data by a picture compression treatment,
a step for transmitting said dummy pictured data compressed in the previous step to a receiving site,
a step (T1) for recovering said data received at said receiving site so as to reproduce said dummy pictured data, and
a step (T2) for dividing said dummy picture into said predetermined number of said original data.

10. Method for compressing and transmitting data, said method **characterized in that** said data consisting of a predetermined number of original data is dummy pictured in the case of transmitting said data to a remote site and dummy pictured data is highly compressed by a picture compression treatment.

11. Method for compressing and transmitting data including important information about characteristic curves, said method **characterized in that** said data consisting of a predetermined number of original data is dummy pictured in the case of transmitting said data to a remote site and dummy pictured data is highly compressed by a picture compression treatment.

12. Method for compressing and transmitting data observed at a plant located at a remote site including important information about characteristic curves, said method **characterized in that** said data consisting of a predetermined number of original data is dummy pictured in the case of transmitting said data to a remote site and dummy pictured data is highly compressed by a picture compression treatment.

13. Method for recovering data, said method **characterized** of comprising:
a step for receiving compressed dummy picture so as to recover said dummy picture,
a step (T1) for reproducing dummy pictured data, and
a step (T2) for reproducing original data by dividing said dummy pictured data reproduced in the previous step into a predetermined number of parts.

14. Method for recovering data including important information about characteristic curves, said method **characterized** of comprising:
a step for receiving compressed dummy pictured data so as to recover said dummy pictured data,
a step (T1) for reproducing dummy pictured data, and
a step (T2) for reproducing original data by dividing said dummy picture reproduced in the previous step into a predetermined number of parts.

15. Method for recovering data observed at a plant located at a remote site including important information about characteristic curves, said method **characterized** of comprising:
a step for receiving compressed dummy pictured data so as to recover said dummy pictured data,
a step (T2) for reproducing dummy pictured data, and
a step (T3) for reproducing original data by dividing said dummy pictured data reproduced in the previous step into a predetermined number of parts.
